# EUROPEAN PATENT SPECIFICATION

(11) **EP 0 383 689 B1**
(45) Date of publication and mention of the grant of the patent: **22.01.1997**
(21) Application number: 90400414.0
(22) Date of filing: 14.02.1990
(51) Int. Cl.: H03M 1/82

(54) **Digital-to-analog converter**
Digital-Analogwandler
Convertisseur numérique-analogique

(30) Priority: 14.02.1989 JP 34570/89
(43) Date of publication of application: 22.08.1990
(73) Proprietor: SONY CORPORATION, Tokyo (JP)
(72) Inventor: Ueki, Masaaki, c/o Sony Corporation, Shinagawa-ku, Tokyo (JP); Masuda, Toshihiko, Sony Corporation, Shinagawa-ku, Tokyo (JP); Kanai, Takashi, Sony Corporation, Shinagawa-ku, Tokyo (JP)
(74) Representative: Thévenet, Jean-Bruno

(56) References cited:
- EP-A- 0 141 386
- EP-A- 0 170 224
- US-A- 4 542 371
- PATENT ABSTRACTS OF JAPAN vol. 12, no. 430 (E-682)(3277) 14 November 1988 & JP-A-63 167 523(NEC HOME ELECTRONICS) 11 July 1988
- PATENT ABSTRACTS OF JAPAN vol. 11, no. 92 (E-491)(2539) 24 March 1987 & JP-A-61 242 119 (NEC IC MICROCOMPUT SYST) 28 October 1986

## Description

### BACKGROUND OF THE INVENTION

### Field of the Invention

This invention relates to a PWM digital-to-analog converter for converting input digital data into a pulse width modulated waveform for conversion into corresponding analog signals.

### Prior Art

There are known in the art various types of digital-to-analog converters for converting input digital signals into corresponding analog signals, such as pulse width modulation or PWM system of converting input digital data into a pulse width modulated waveform, or pulse amplitude modulation or PAM system of converting input digital data into a pulse amplitude modulated waveform, for conversion into corresponding analog signals.

On the other hand, in digital audio signal processing systems, such as CD or DAT, there are proposed, as a technique of reducing quantization noises at the time of decoding analog audio signals from digital data, an oversampling technique of converting digital data with a sampling frequency fs according to the Nyquist's theorem into an n-number multiple sampling frequency n·fs, or a noise shaping technique of changing frequency distribution characteristics of the noise for improving the S/N ratio. For example, as disclosed in the Japanese Patent Publication 61-177819 (1986), digital data which are previously subjected to the above mentioned oversampling or noise-shaping are converted into an analog form by a digital-to-analog converter to produce analog audio signals with a reduced quantization noise level.

Meanwhile, although it is possible in principle with the above mentioned PAM digital analog converter to produce converted analog output signals with excellent linearity and reduced distortion, it is beset with a drawback that high accuracy resistance summation or current summation circuits, accurately registering with the weights to the input digital data bits, are necessitated, and that, if it is desired to improve the resolution, the circuit scale is increased and the circuit as a whole need be designed with high accuracy.

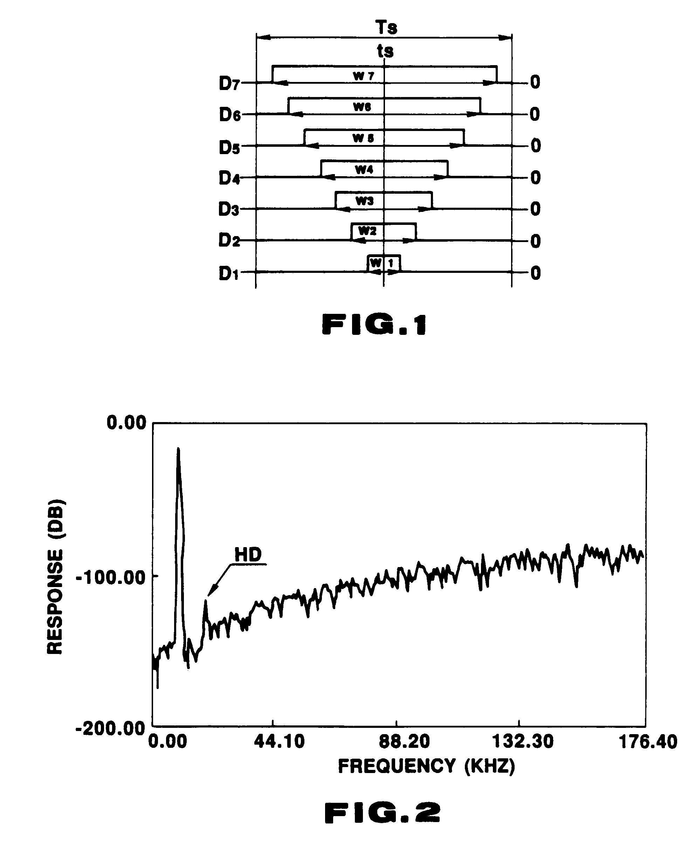

On the other hand, although the above mentioned PWM digital-to-analog converters are simplified in circuit organization, the conventional PWM digital-to-analog converters in which, as shown in Fig. 1, a pulse width modulated waveform having pulse widths W₇, W₆, W₅, W₄, W₃, W₂ and W₁ consistent with 3-bit 7-value input digital data D₇, D₆, D₅, D₄, D₃, D₂ and D₁ are generated and freed of high frequency components in a low-pass filter to produce analog output signals, is beset with an inconvenience that, as shown in the spectral distribution diagram of Fig. 2, which illustrates the results of the FFT analyses of the pulse width modulated waveform, generated from the 10kHz sinusoidal signal, the even-number order distortion components, above all, the second order distortion components HD, are increased.

US Patent 4 542 371 describes a digital-to-analog converter according to the pre-characterising portion of claim 1, adapted to reduce second harmonic component distortion in the output analog signal.

### OBJECTS AND SUMMARY OF THE INVENTION

It is therefore an object of the present invention to provide a PWM digital-to-analog converter in which the even-number order distortion components may be reduced.

It is another object of the present invention to provide a digital-to-analog converter of a simplified circuit organization, which is low in distortion factor and excellent in conversion characteristics.

It is a further object of the present invention to provide an arrangement in which a decoded output signal with reduced distortion may be produced in a decoding section of a digital audio signal processing system.

In accordance with the present invention, there is provided a digital-to-analog converter, comprising:
first pulse width modulated waveform generating means for generating a pulse width modulated waveform consistent with input digital data;
second pulse width modulated waveform generating means for generating a second pulse width modulated waveform consistent with the complement of said input digital data;
differential amplifying means for deriving a differential component of the first and second pulse width modulated waveforms output by said first and second pulse width modulated waveform generating means; and
filter means for outputting an analog output signal freed of high frequency components of the differential output waveform output by the differential amplifying means;
wherein a differential component between the pulse width modulated waveforms consistent with input digital data and with complement data of said input digital data is output by the differential amplifying means and freed of high frequency components to produce analog output signals;
characterised in that:
the second pulse width modulated waveform generating means is adapted for generating the second pulse width modulated waveform consistent with the 2's complement of the input digital data;
a first low pass filter is provided between the first pulse width modulated waveform generating means and the differential amplifying means; and
a second low pass filter is provided between the second pulse width modulated waveform generating means and the differential amplifying means.

Thus, with the digital-to-analog converter according to the present invention, a differential component between the low pass filtered pulse width modulated waveform consistent with input digital data generated by first pulse width modulated waveform generating means and the low pass filtered pulse width modulated waveform consistent with the 2's complement data of the input digital data generated by second pulse width modulated waveform generating means, is taken out from differential amplifying means, and the differential output waveform produced by the differential amplifier means is freed of high frequency components by filter means to produce analog output signals. In this manner, the even-number order distortion components may be reduced to improve the distortion factor.

The above and other objects and novel features of the present invention will become apparent from the following description and the appended claims.

### BRIEF DESCRIPTION OF THE DRAWINGS

Fig. 1 is a waveform diagram showing the PWM waveform in a conventional PWM digital-to-analog converter.

Fig. 2 shows spectrum distribution showing the results of the FFT analyses of the PWM waveform shown in Fig. 1.

Fig. 3 is a block diagram of a digital data decoding system to which the digital-to-analog converter according to the present invention is applied.

Fig. 4 is a waveform diagram showing the pulse width modulated waveform from a first pulse width modulated waveform generator forming part of the digital-to-analog converter shown in Fig. 3.

Fig. 5 is a waveform diagram showing the pulse width modulated waveform from a second pulse width modulated waveform generator forming part of the digital-to-analog converter shown in Fig. 3.

Fig. 6 is a waveform diagram showing the differential output waveform by a differential amplifier forming part of the digital-to-analog converter shown in Fig. 3.

Fig. 7 shows spectrum distribution showing the results of the FFT analyses of the differential output waveform of the differential amplifier shown in Fig. 6.

### EMBODIMENT

By referring to the drawings, a preferred embodiment of a digital-to-analog converter of the present invention will be explained in detail.

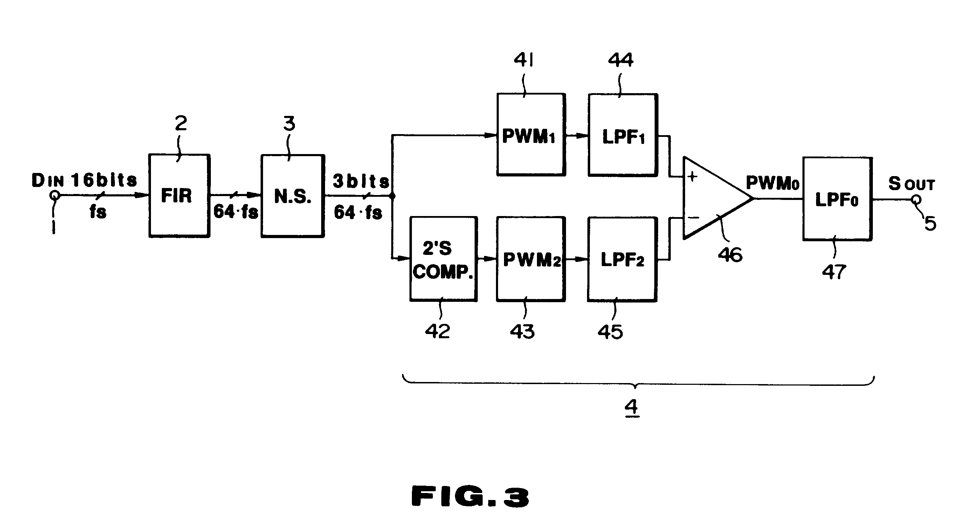

In an embodiment shown in Fig. 3, the present invention is applied to a decoding system in a digital audio signal processing system wherein 16-bit playback digital audio data D_{IN} are supplied via an input terminal 1 to an oversampling section 2.

The oversampling section 2 performs an oversampling on the playback digital audio data D_{IN} for converting it into digital data having a frequency 64·fs, which is 64 times the sampling frequency fs, and transmits the oversampled digital data to a noise shaping section 3.

The noise shaping section 3 performs a noise shaping on the oversampled 16-bit digital data from the oversampling section 2 for rounding it to a 3-bit 7-value digital data for removing the quantization error, and transmits the noise shaped 3-bit 7-value digital data to a digital-to-analog converter 4 of the present invention.

The digital-to-analog converter 4 is constituted by a first pulse width modulated waveform generator 41 for generating a pulse width modulated waveform PWM₁ corresponding to the noise-shaped 3-bit 7-valued input digital data from the noise shaping section 3, a 2's complement converter 42 for converting the input digital data into 2's complement data, a second pulse width modulated waveform generator 43 for generating a pulse width modulated waveform PWM₂, a differential amplifier 46 to the input of which pulse width modulated waveform outputs by the first and second pulse width modulated waveform generators 41, 43 are supplied via low-pass filters 44, 45 respectively, and a low-pass filter 47 for eliminating a high frequency component of the differential output waveform from the differential amplifier 46.

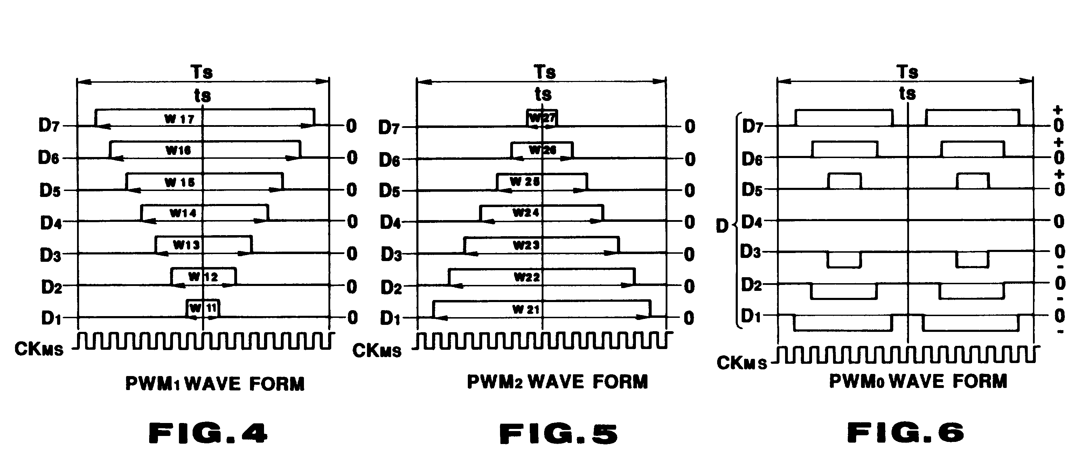

The first pulse width modulated waveform generator 41 receives a 3-bit 7-value input digital data from the noise shaping section 3, and generates, in synchronism with a master clock CK_{MS}, a pulse width modulated waveform PWM₁ having pulse widths W₁₇, W₁₆, W₁₅, W₁₄, W₁₃, W₁₂ and W₁₁, which are consistent with the input digital data and which are symmetrical with respect to a central timing ts of one sampling period Ts, as shown in Fig. 4.

The second pulse width modulated waveform generator 43 generates, in synchronism with the master clock CK_{MS}, a pulse width modulated waveform PWM₂ having pulse widths W₂₇, W₂₆, W₂₅, W₂₄, W₂₃, W₂₂ and W₂₁ which are consistent with 2's complement data of the input digital data D₇, D₆, D₅, D₄, D₃, D₂ and D₁ from the 2's complement converter 42 and which are symmetrical with respect to the central timing ts of one sampling period Ts.

Thus the first and second pulse width modulating waveform generators 41, 43 receive the input digital data D₇, D_{6,} D₅, D₄, D₃, D₂ and D₁, and generate, in synchronism with the master clock CK_{MS}, pulse width modulated waveforms PWM₁, PWM₂ having pulse widths defined by W₁₇=W₂₁, W₁₆=W₂₂, W₁₅=W₂₃, W₁₄=W₂₄, W₁₃=W₂₅, W₁₂=W₂₆ and W₁₁=W₂₇ and symmetrical with respect to the central timing ts of one sampling period Ts.

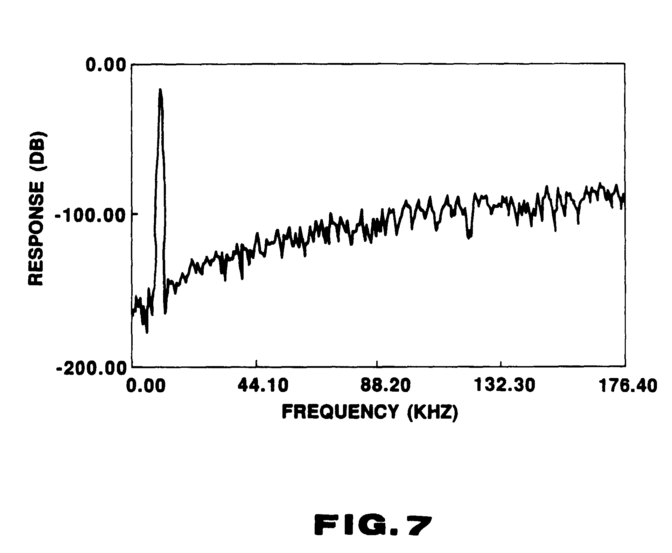

The pulse width modulated waveform outputs PWM₁, PWM₂ from the first and second pulse width modulated waveform generators 41, 43 are supplied via low-pass filters 44, 45 to the input of the differential amplifier 46, from which a differential output PWM₀ for the input digital data D₇, D₆, D₅, D₄, D₃, D₂ and D₁ as shown in Fig. 6 is produced as a differential output between the pulse width modulated waveforms PWM₁, PWM₂.

The low-pass filters 44, 45 function to limit the tilt of rising and falling edges of the pulse width modulated waveform outputs PWM₁ and PWM₂ from the first and second pulse width modulated waveform generators 41, 43 to a tilt consistent with the response speed of the differential amplifier 46. These low-pass filters 44, 45 may be omitted in principle if the differential amplifier 46 having ideal operating characteristics is employed.

This digital-to-analog converter 4 eliminates the high frequency component of the differential output waveform PWM₀ from the differential amplifier 46, by means of the low-pass filter 47 to output an analog output signal S_{OUT}, consistent with the input digital data D₇, D₆, D₅, D₄, D₃, D₂ and D₁ that is, the 16-bit playback digital audio data D_{IN} supplied to the input terminal 1, at signal output terminal 5.

With the digital-to analog converter 4 of the present embodiment, as shown in the spectrum distribution diagram of Fig. 7, which illustrates the results of FFT analyses on the differential output waveform PWM₀ obtained by the differential amplifier 45 from 10kHz sinusoidal digital data, waveform distortion of the even number order, especially the second order, may be reduced for realizing a digital-to-analog converter of a simplified structure which is low in distortion factor and superior in conversion characteristics.

With the digital-to-analog converter 4 of the present illustrative embodiment, the input digital data are supplied via the 2's complement circuit 42 to the second pulse width modulated waveform generator 43. However, each of the first and the second pulse width modulated waveform generators 41, 43 may be constituted by a lookup table memory in which pulse width modulated waveform data PWM₁, PWM₂ of the various pulse widths, having the input digital data D₇, D₆, D₅, D₄, D₃, D₂ and D₁ as the readout addresses, as shown in Table 1, are stored in advance, while the pulse width modulated waveform PWM₁, PWM₂ may be directly formed from the input digital data D₇, D₆, D₅, D₄, D₃, D₂ and D₁ by the first and second pulse width modulated waveform generators 41, 43.

**Table 1**

| | Pulse width modulation output | |
|---|---|---|
| Address | PWM₁ | PWM₂ |
| D₇ | W₁₇ | W₂₁ |
| D₆ | W₁₆ | W₂₂ |
| D₅ | W₁₅ | W₂₃ |
| D₄ | W₁₄ | W₂₄ |
| D₃ | W₁₃ | W₂₅ |
| D₂ | W₁₂ | W₂₆ |
| D₁ | W₁₁ | W₂₇ |

## Claims

1. A digital-to-analog converter, comprising:
a first pulse width modulated waveform generating means (41) for generating a first pulse width modulated waveform consistent with input digital data;
a second pulse width modulated waveform generating means (42,43) for generating a second pulse width modulated waveform consistent with the complement of said input digital data;
differential amplifying means (46) for deriving a differential component of the first and second pulse width modulated waveforms output by said first and second pulse width modulated signal generating means; and
filter means (47) for outputting an analog output signal free of high frequency components of the differential waveform output by the differential amplifying means;
whereby a differential component between the pulse width modulated waveforms consistent with the input digital data and with complement data of said input digital data is output by the differential amplifying means and freed of high frequency components to produce analog output signals;
characterised in that:
the second pulse width modulated waveform generating means (42,43) is adapted for generating the second pulse width modulated waveform consistent with the 2's complement of the input digital data;
a first low pass filter (44) is provided between the first pulse width modulated waveform generating means (41) and the differential amplifying means (46); and
a second low pass filter (45) is provided between the second pulse width modulated waveform generating means (42,43) and the differential amplifying means (46).

2. The digital-to-analog converter according to claim 1, wherein said second pulse width modulated waveform generating means comprises a 2's complement converting circuit (42) for converting input digital data into 2's complement data and a pulse width modulated waveform generating circuit (43) supplied with the output of said 2's complement converting circuit (42) and generating a pulse width modulated waveform consistent with the 2's complement data of said input digital data.

3. The digital-to-analog converter according to claim 1, wherein said second pulse width modulated signal generating means comprises a pulse width modulated waveform generating circuit including a look-up table memory for outputting pulse width modulated waveform data consistent with 2's complement data of input digital data.

4. The digital-to-analog converter according to claim 1, further comprising:
oversampling means (2) for subjecting playback digital data to an oversampling operation, and
noise shaping means (3) for eliminating quantization errors of output data from said oversampling means (2);
wherein said playback data is supplied to said first (41) and second (42,43) pulse width modulated waveform generating means as said input digital data by way of said oversampling means (2) and said noise shaping means (3).

## Patentansprüche

1. Digital-Analogwandler mit
einem ersten pulsbreitenmodulierten Pulsformgenerator (41) zur Erzeugung einer ersten den digitalen Eingangsdaten entsprechenden pulsbreitenmodulierten Pulsform;
einem zweiten pulsbreitenmodulierten Pulsformgenerator (42, 43) zur Erzeugung einer dem Komplement der digitalen Eingangsdaten entsprechenden pulsbreitenmodulierten Pulsform;
einem Differentialverstärker (46) zur Ableitung einer Differentialkomponente der von dem ersten und zweiten pulsbreitenmodulierten Signalgenerator ausgegebenen ersten und zweiten pulsbreitenmodulierten Pulsformen; und
einem Filter (47) zur Ausgabe eines analogen Ausgangssignales, welches frei von Hochfrequenzanteilen der von dem Differentialverstärker ausgegebenen Differentialpulsform ist;
wobei eine Differentialkomponente zwischen den den digitalen Eingangsdaten und den Komplementärdaten der digitalen Eingangsdaten entsprechenden pulsbreitenmodulierten Pulsformen von dem Differentialverstärker ausgegeben und von Hochfrequenzanteilen befreit wird, um analoge Ausgangssignale zu erzeugen;
**dadurch gekennzeichnet**, daß
der zweite pulsbreitenmodulierte Pulsformgenerator (42, 43) zur Erzeugung der zweiten pulsbreitenmodulierten Pulsform entsprechend dem Zweierkomplement der digitalen Eingangsdaten angepaßt ist;
ein erster Tiefpaßfilter (44) zwischen dem ersten pulsbreitenmodulierten Pulsformgenerator (41) und dem Differentialverstärker (46) vorgesehen ist; und
ein zweiter Tiefpaßfilter (45) zwischen dem zweiten pulsbreitenmodulierten Pulsformgenerator (42, 43) und dem Differentialverstärker (46) vorgesehen ist.

2. Digital-Analogwandler nach Anspruch 1,
wobei der zweite pulsbreitenmodulierte Pulsformgenerator eine Zweierkomplement-Konvertierungsschaltung (42) zur Umsetzung digitaler Eingangsdaten in Zweierkomplementärdaten und eine pulsbreitenmodulierte Pulsformgeneratorschaltung (43) aufweist, der das Ausgangssignal der Zweierkomplementär-Konvertierungsschaltung (42) zugeführt wird und die eine pulsbreitenmodulierte Pulsform entsprechend den Zweierkomplementärdaten der digitalen Eingangsdaten erzeugt.

3. Digital-Analogwandler nach Anspruch 1,
wobei der zweite pulsbreitenmodulierte Signalgenerator eine pulsbreitenmodulierte Pulsformgeneratorschaltung mit einem Tabellenspeicher zur Ausgabe von pulsbreitenmodulierten Pulsformdaten entsprechend den Zweierkomplementärdaten der digitalen Eingangsdaten aufweist.

4. Digital-Analogwandler nach Anspruch 1 mit
einer Überabtastungs-Vorrichtung (2), um die digitalen Wiedergabedaten einer Überabtastung zu unterziehen, und
einer Rauschformungs-Vorrichtung (3) zur Beseitigung von Quantisierungsfehlern der Ausgangsdaten aus der Überabtastungs-Vorrichtung (2);
wobei die Wiedergabedaten dem ersten (41) und zweiten (42, 43) pulsbreitenmodulierten Pulsformgenerator als digitale Eingangsdaten mittels der Überabtastungs-Vorrichtung (2) und der Rauschformungs-Vorrichtung (3) zugeführt werden.

## Revendications

1. Convertisseur numérique-analogique comprenant :
un premier moyen de génération de forme d'onde modulée en largeur d'impulsion (41) pour générer une première forme d'onde modulée en largeur d'impulsion cohérente avec des données numériques d'entrée ;
un second moyen de génération de forme d'onde modulée en largeur d'impulsion (42, 43) pour générer une seconde forme d'onde modulée en largeur d'impulsion cohérente avec le complément desdites données numériques d'entrée ;
un moyen d'amplification différentielle (46) pour dériver une composante différentielle des première et seconde formes d'onde modulées en largeur d'impulsion émises en sortie par lesdits premier et second moyens de génération de signal modulé en largeur d'impulsion; et
un moyen de filtre (47) pour émettre en sortie un signal de sortie analogique exempt de composantes haute fréquence de la forme d'onde différentielle émise en sortie par le moyen d'amplification différentielle ;
et ainsi, une composante différentielle entre les formes d'onde modulées en largeur d'impulsion cohérentes avec les données numériques d'entrée et avec des données complémentaires desdites données numériques d'entrée est émise en sortie par le moyen d'amplification différentielle et est rendue exempte de composantes haute fréquence pour produire des signaux de sortie analogiques,
caractérisé en ce que : le second moyen de génération de forme d'onde modulée en largeur d'impulsion (42, 43) est adapté pour générer la seconde forme d'onde modulée en largeur d'impulsion cohérente avec le complément à 2 des données numériques d'entrée ;
un premier filtre passe-bas (44) est prévu entre le premier moyen de génération de forme d'onde modulée en largeur d'impulsion (41) et le moyen d'amplification différentielle (46); et
un second filtre passe-bas (45) est prévu entre le second moyen de génération de forme d'onde modulée en largeur d'impulsion (42, 43) et le moyen d'amplification différentielle (46).

2. Convertisseur numérique-analogique selon la revendication 1, dans lequel ledit second moyen de génération de forme d'onde modulée en largeur d'impulsion comprend un circuit de conversion de complément à 2 (42) pour convertir des données numériques d'entrée en données de complément à 2 et un circuit de génération de forme d'onde modulée en largeur d'impulsion (43) qui se voit appliquer la sortie dudit circuit de conversion de complément à 2 (42) et qui génère une forme d'onde modulée en largeur d'impulsion cohérente avec les données de complément à 2 desdites données numériques d'entrée.

3. Convertisseur numérique-analogique selon la revendication 1, dans lequel ledit second moyen de génération de signal modulé en largeur d'impulsion comprend un circuit de génération de forme d'onde modulée en largeur d'impulsion incluant une mémoire de table de consultation pour émettre en sortie des données de forme d'onde modulée en largeur d'impulsion cohérentes avec des données de complément à 2 de données numériques d'entrée.

4. Convertisseur numérique-analogique selon la revendication 1, comprenant en outre :
un moyen de sur-échantillonnage (2) pour soumettre des données numériques de lecture à une opération de sur-échantillonnage; et
un moyen de mise en forme de bruit (3) pour éliminer des erreurs de quantification de données émises en sortie depuis ledit moyen de sur-échantillonnage (2),
dans lequel lesdites données de lecture sont appliquées sur lesdits premier (41) et second (42, 43) moyens de génération de forme d'onde modulée en largeur d'impulsion en tant que dites données numériques d'entrée à l'aide dudit moyen de sur-échantillonnage (2) et dudit moyen de mise en forme de bruit (3).
